# EUROPEAN PATENT APPLICATION

(11) **EP 4 093 160 A1**
(43) Date of publication of application: **23.11.2022**
(21) Application number: 21174994.0
(22) Date of filing: 20.05.2021
(51) Int. Cl.: H05K 1/14, H01R 12/73, H05K 1/11, H05K 1/18, H05K 3/00, H05K 3/34, G09F 9/00, G09G 3/00, H01L 27/14

(54) **PRINTED CIRCUIT BOARD ASSEMBLY, CONNECTOR, SYSTEM COMPRISING A PRINTED CIRCUIT BOARD ASSEMBLY AND A CONNECTOR, AND A METHOD OF REPAIRING A PRINTED CIRCUIT BOARD ASSEMBLY**

(71) Applicant: Vestel Elektronik Sanayi ve Ticaret A.S., 45030 Manisa (TR)
(72) Inventor: KURALAY, Fatih, 45030 Manisa (TR)
(74) Representative: Kehl, Ascherl, Liebhoff & Ettmayr Patentanwälte Partnerschaft mbB

(57) **Abstract**

The present invention provides a technique for repairing a damaged printed circuit board assembly (PCBA, 20), wherein the PCBA (20) at least comprises a printed circuit board, a plurality of electronic components mounted on a front surface of the printed circuit board and a plurality of electrically conducting connections (26, 28) between the electronic components on a rear surface of the printed circuit board. The technique comprises providing the PCBA (20) with a laser cutting line (30), which is positioned to cut between the electronic components on the front surface but across the electrically conducting connections (26, 28) on the rear surface. The laser cutting line (30) is arranged parallel to an edge of the PCBA (20). Each of the electrically conducting connections (26, 28) traversed by the laser cutting line (30) is electrically connected to at least one electrically conducting pad of a connector-receiving portion also on the rear surface, which is located on an opposite side of the laser cutting line (30) from the edge of the PCBA (20) which the laser cutting line (30) is parallel to. Thus if the PCBA (20) is accidentally damaged at its edge or corner, the damaged area may be removed by cutting along the laser cutting line (30) with a laser, and inserting a replacement part of PCBA (20R) having the same shape and size as the removed part of the PCBA (20) into the hole left behind by the removed part of the PCBA (20). The replacement part of PCBA (20R) also comprises a connector-receiving portion adjacent one of its edges, which is similar to the connector-receiving portion of the damaged PCBA (20). The invention also provides a connector, which is adapted to engage with the connector-receiving portions of the damaged PCBA (20) and the replacement part of PCBA (20R). By means of this connector, the replacement part of PCBA (20R) can be mechanically and electrically connected to the damaged PCBA (20), thereby repairing it. This obviates the need to scrap and replace the entire PCBA (20) if it is accidentally damaged at its edge or corner, which saves costs.

## Description

### TECHNICAL FIELD

The present invention relates to a printed circuit board assembly according to claim 1, a connector according to claim 9, a system comprising such a printed circuit board assembly and such a connector according to claim 13, and a method of repairing a printed circuit board assembly according to claim 15.

### Background of the Invention

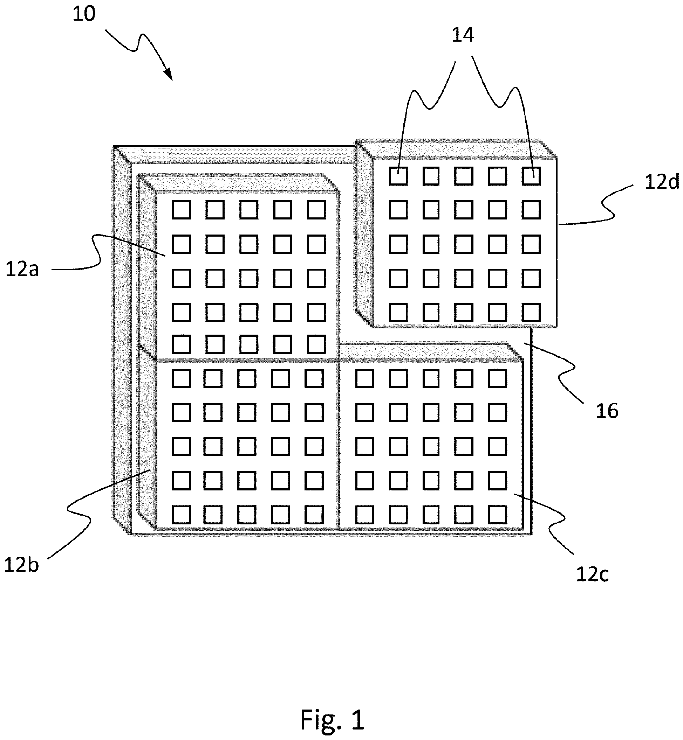

Fig. 1 schematically shows an LED display 10, which comprises a plurality of LED display modules 12a, 12b, 12c, 12d mounted in a cabinet 16. Each of the LED display modules 12a, 12b, 12c, 12d comprises a housing (typically made of a plastics material), containing a printed circuit board, on a front surface of which is arranged an array of LED packages 14. As well as the LED display modules 12a, 12b, 12c, 12d, the LED display 10 also comprises a hub board and a receiving card (neither of which is shown in Fig. 1). A plurality of such LED displays 10 can be arranged side-by-side in a grid to form an LED display wall.

The pitch of the LED packages 14 may, for example, be 2.5 mm between adjacent LED packages 14. If, for example, one of the LED display modules 12a, 12b, 12c, 12d contains an array of 100 x 100 such LED packages 14, the total number of LED packages 14 thereon will therefore be 10 000. When such a large number of LED packages 14 is combined with the associated copper wiring, other electronic components such as drivers for the LED packages 14, capacitors and connectors, this makes the LED display modules 12a, 12b, 12c, 12d expensive items, also considering the time and effort which are invested in their manufacture.

Depending on the pitch of the LED packages 14, the LED display modules 12a, 12b, 12c, 12d typically represent 60 to 70% of the total cost of an LED display wall.

On the other hand, LED display modules are also rather fragile devices because an operator or user can directly contact the array of LED packages 14 and/or the printed circuit board on which they are arranged. In particular, the printed circuit board assembly (PCBA), which comprises the printed circuit board itself, the array of LED packages 14 and other electronic components mounted thereon, and their associated electrical connections, is particularly vulnerable to damage at its corners and edges. A single small damage to the PCBA may render it unusable, for example because an entire row or column of LEDs will no longer light up following the damage. In such a case, the entire LED display module may have to be scrapped and replaced, which is a significant problem and clearly undesirable.

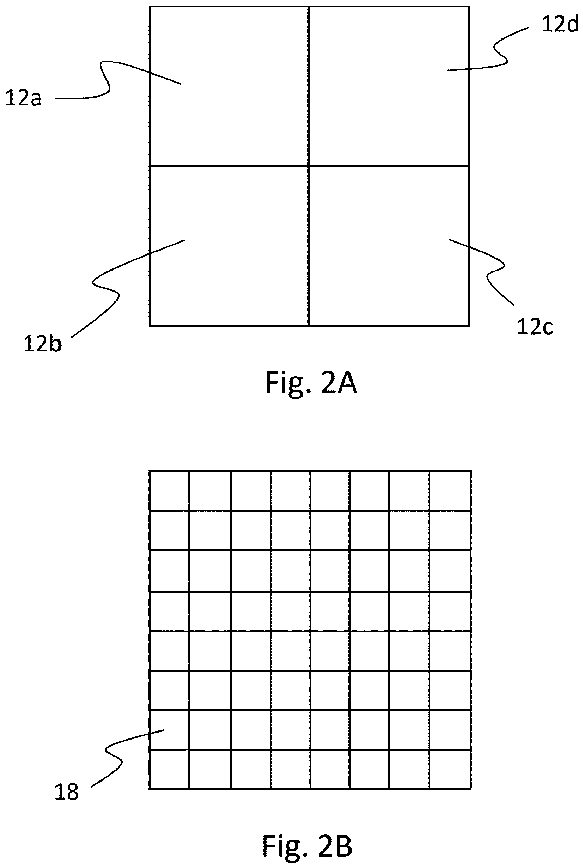

An LED display 10 typically comprises four such LED display modules 12a, 12b, 12c, 12d, as is schematically shown in Fig. 2A. One possible solution to the above problem of their vulnerability to damage, therefore, might be to make each of the individual LED display modules smaller, as in Fig. 2B, which schematically shows an LED display of the same overall size as that shown in Fig. 2A, but which instead comprises a larger number (64) of mini LED display modules 18. Then if one of the mini LED display modules 18 is accidentally damaged, it may be scrapped and replaced, whilst leaving all of the remaining undamaged ones of the mini LED display modules 18 in place.

However, this possible solution, although attractive at first sight, is not cost effective because it vastly increases the number of connectors required between the larger number of mini LED display modules 18 than are required in the case of the LED display 10 shown in Fig. 2A. It also increases the size of the hub board which the LED display 10 requires. Moreover, the number of output control ports of the controllers and drivers for the LED packages 14 also increases, which may require the use of a higher power controller than is needed for the LED display 10 of Fig. 2A, again increasing cost. Finally, such a larger number of mini LED display modules 18, together with the associated other adaptations just described will not fit into a standard LED display cabinet 16 of the type commonly available on the market. This would therefore require the design of a bespoke replacement cabinet as well.

Other background prior art is described in CN 111787682 A, which discloses a patch pasting plate structure. The structure comprises a PCB patch board, and installation structures are fixedly installed at the positions, close to the four corners, of the side face of the PCB patch board. A heat dissipation mechanism is fixedly embedded in the middle of the PCB patch board. An LED patch is fixedly installed on the upper surface of the heat dissipation mechanism, the portions, located on the two sides of the LED patch, of the upper surface of the PCB patch board are fixedly filled with filling soldering tin, the upper surface of the filling soldering tin is fixedly sprayed with insulating paint, and an element patch is fixedly installed on the upper surface of the PCB patch board.

### Object of the Invention

It is therefore an object of the invention to address the above-described problem of the vulnerability to damage of LED display modules. Accordingly, it is an object of the invention to provide a printed circuit board assembly, a connector, a system comprising such a printed circuit board assembly and such a connector, and a method of repairing a printed circuit board assembly.

### Description of the Invention

The object of the invention is solved by a printed circuit board assembly according to claim 1. The printed circuit board assembly comprises a printed circuit board, a plurality of evenly spaced electronic components mounted on a front surface of the printed circuit board, and a plurality of electrically conducting connections between the electronic components on a rear surface of the printed circuit board. The rear surface of the printed circuit board further comprises a connector-receiving portion. The connector-receiving portion comprises a plurality of screw holes perpendicular to the front and rear surfaces of the printed circuit board, and a plurality of evenly spaced, electrically conducting pads. Each of the electrically conducting connections on the rear surface of the printed circuit board is electrically connected to at least one of the electrically conducting pads. In addition, a separation between the screw holes is equal to an integral multiple of the spacing between the electronic components on the front surface, and the respective locations of the screw holes is offset from the respective locations of the electronic components on the front surface by half the spacing between the electronic components on the front surface.

This solution is beneficial because if the printed circuit board assembly is accidentally damaged, the damaged area of the printed circuit board assembly can be removed and the connector-receiving portion can be used to connect the remainder of the printed circuit board assembly to a replacement part. Since the connector-receiving portion comprises both a plurality of screw holes and a plurality of electrically conducting pads, the replacement part can be connected to the connector-receiving portion both mechanically and electrically, using the screw holes to attach the replacement part mechanically and using the electrically conducting pads to make electrical connections to the replacement part. Since each of the electrically conducting connections on the rear surface of the printed circuit board is electrically connected to at least one of the electrically conducting pads, all of the electrical connections to the electronic components on the front surface of the printed circuit board can be re-established even if the electrically conducting connections on the rear surface are cut when the damaged area is removed. Since a separation between the screw holes is equal to an integral multiple of the spacing between the electronic components on the front surface, and the respective locations of the screw holes is offset from the respective locations of the electronic components on the front surface by half the spacing between the electronic components on the front surface, the locations of the screw holes do not interfere with the mounting of the electronic components on the front surface. Instead, the screw holes are located in gaps between rows and/or columns of the electronic components mounted on the front surface of the printed circuit board.

Advantageous embodiments of the invention may be configured according to any claim and/or part of the following description.

In some embodiments, each of the electrically conducting pads of the connector-receiving portion may comprise a blind hole perpendicular to the rear surface of the printed circuit board. This solution is beneficial because it allows electrically conducting leads to be inserted into the blind holes for a more secure electrical connection than can be made by a pad alone. The holes are blind because they do not penetrate through to the front surface of the printed circuit board. The fact that the holes are blind prevents these holes from interfering with the mounting of the electronic components on the front surface of the printed circuit board. The depth of the blind holes can be determined by the thickness of the printed circuit board.

Whereas the electronic components mounted on the front surface of the printed circuit board can be any electronic components which are evenly spaced in the manner of an array, preferably, each of the evenly spaced electronic components comprises an LED package.

In some embodiments, the printed circuit board assembly further comprises a line for laser cutting between the electronic components on the front surface of the printed circuit board and across the electrically conducting connections on the rear surface of the printed circuit board, wherein the line for laser cutting is aligned parallel to an edge of the printed circuit board. In addition, the screw holes are arranged on the opposite side of the line from said edge, and the electrically conducting pads are arranged on the same side of the line as the screw holes. This solution is beneficial because if the printed circuit board assembly is accidentally damaged either along the edge or at one of the corners at each end of the edge, which are the most likely locations for such damage to occur, the line for laser cutting can be used to remove a part of the edge and/or corner which includes the damaged area. On the other hand, since both the screw holes and the electrically conducting pads are arranged on the opposite side of the line from said edge, the screw holes and the electrically conducting pads remain on the printed circuit board assembly after the damaged area has been removed by cutting along at least a part of the line.

If the printed circuit board assembly comprises such a line for laser cutting, in some embodiments, the rear surface of the printed circuit board preferably comprises at least two of said lines for laser cutting which are arranged perpendicular to each other, and a plurality of connector-receiving portions are arranged on the opposite sides of the at least two lines from at least two edges of the rear surface. This solution is beneficial because it allows a plurality of such printed circuit board assemblies to be assembled edgewise in an array, in the manner shown, for example in Fig. 2A, with the entire periphery of the array having edges and corners which can be removed and replaced if they are accidentally damaged, using at least one of the lines for laser cutting and at least one of the connector-receiving portions which are located near to the damaged edge and/or corner.

If the printed circuit board assembly comprises a plurality of connector-receiving portions as just described, preferably, a gap between adjacent ones of the plurality of connector-receiving portions is not greater than one-and-a-half times a length of the connector-receiving portions themselves. This solution is beneficial because an accidentally damaged area of the printed circuit board assembly will then never be very far away from a connector-receiving portion to allow a suitable repair to be carried out.

In some embodiments, the printed circuit board of the printed circuit board assembly may be rectangular in shape, having two short edges and two long edges, and a connector-receiving portion may be arranged alongside at least one of the two long edges. This solution is beneficial because such a printed circuit board assembly may then be used as a replacement part for a damaged area which has been removed from another printed circuit board assembly by laser cutting along a line aligned parallel to an edge of the other printed circuit board assembly leaving a rectangular hole. Since the connector-receiving portion is arranged alongside at least one of the two long edges of the rectangular printed circuit board assembly, it is conveniently located for connection to a similar connector-receiving portion on the remainder of the damaged printed circuit board assembly.

If the printed circuit board is rectangular with a connector-receiving portion arranged alongside at least one of its two long edges as just described, in some embodiments, the connector-receiving portion preferably has a length which is shorter than the two short edges of the rectangular printed circuit board. This solution is beneficial because it allows such a rectangular printed circuit board assembly to be inserted as a replacement part at a damaged corner of another printed circuit board assembly which has at least two lines for laser cutting arranged perpendicular to each other at the damaged corner, without obstructing an adjacent edge of the damaged printed circuit board assembly. Thus if the damaged printed circuit board assembly is repaired at its corner using such a replacement part, but has another damaged area on an edge adjacent to the damaged corner, that damaged edge can be repaired as well, using the same technique.

The present invention also relates to a connector suitable for connecting the connector-receiving portions of two different printed circuit board assemblies together, wherein one of the printed circuit board assemblies has been damaged and is subject to repair, and the other of the printed circuit board assemblies is being used as a replacement part for the damaged area. The connector comprises a rigid, electrically insulating elongate body, whose length defines a first direction, a first plurality of rigid, electrically insulating arms projecting from the elongate body in a second direction perpendicular to the first direction, and a second plurality of rigid, electrically insulating arms projecting from the elongate body in a third direction opposite to the second direction. Each respective one of the first plurality of arms is mechanically connected to a respective one of the second plurality of arms, and each of the arms respectively comprises a through-hole in a fourth direction perpendicular to the first and second directions. The connector further comprises a first plurality of evenly spaced, electrically conducting pins projecting from the elongate body in the second direction, and a second plurality of evenly spaced, electrically conducting pins projecting from the elongate body in the third direction. Each respective one of the first plurality of pins is electrically connected to a respective one of the second plurality of pins. Moreover, a separation between the through-holes in the first plurality of arms is equal to a separation between the through-holes in the second plurality of arms.

This solution is beneficial because the elongate body and arms of the connector allow a strong mechanical connection to be made between the two printed circuit board assemblies by inserting screws through the through-holes into the screw holes in the two printed circuit board assemblies. The two pluralities of electrically conducting pins also allow electrical connections to be made between the two printed circuit board assemblies by soldering one of the pluralities of pins to the electrically conducting pads on one of the two printed circuit board assemblies and the other of the pluralities of pins to the electrically conducting pads on the other of the two printed circuit board assemblies. Since a separation between the through-holes in the first plurality of arms is equal to a separation between the through-holes in the second plurality of arms, the spacing between the electronic components on the front surface of one of the two printed circuit board assemblies can also be matched to the spacing between the electronic components on the front surface of the other of the two printed circuit board assemblies.

In some embodiments, each of the electrically conducting pins may respectively comprise a lead projecting from its respective pin in the fourth direction. This solution is beneficial because it allows the leads to be inserted into blind holes of the pads of the connector-receiving portions of the two printed circuit board assemblies for a more secure electrical connection between them.

If the pins comprise such leads, in some embodiments, all of the arms and all of the pins each preferably have a respective flat surface, which surfaces are coplanar with each other and together define a plane from which the leads of the pins project. This solution is beneficial because the connector then sits flush with the rear surfaces of the two printed circuit board assemblies, thereby increasing the strength of their mechanical connection.

In some embodiments, the through-holes in the arms of the connector may be internally threaded to hold a screw in each of them. This solution is beneficial because it makes it easier to screw the connector to the two printed circuit board assemblies.

The present invention also relates to a system comprising a first printed circuit board assembly as described herein and a connector as described herein, wherein the size of and separation between the respective through-holes of the connector is equal to the size of and separation between the respective screw holes in the first printed circuit board assembly, and the spacing between the first plurality of pins of the connector is equal to the spacing between the electrically conducting pads on the first printed circuit board assembly.

This solution is beneficial because the size and configuration of the connector are then matched to the layout of the connector-receiving portion on the first printed circuit board assembly, both mechanically and electrically.

In some embodiments, the system may further comprise a second printed circuit board assembly as described herein, wherein the size of and separation between the respective screw holes in the second printed circuit board assembly is equal to the size of and separation between the respective through-holes of the connector, and the spacing between the electrically conducting pads on the second printed circuit board assembly is equal to the spacing between the second plurality of pins of the connector. This solution is beneficial because the layout of the connector-receiving portion on the second printed circuit board assembly is then matched to the size and configuration of the connector, both mechanically and electrically. It therefore follows that the layout of the connector-receiving portion on the second printed circuit board assembly is also matched to the layout of the connector-receiving portion on the first printed circuit board assembly, allowing the two printed circuit board assemblies to be connected together.

Finally, the present invention also relates to a method of repairing a printed circuit board assembly. The method comprises providing a first printed circuit board assembly as described herein, removing a part of the first printed circuit board assembly by laser cutting, including cutting along a line for laser cutting between the electronic components on the front surface of the printed circuit board of the first printed circuit board assembly and across the electrically conducting connections on the rear surface of the printed circuit board of the first printed circuit board assembly, to leave a remainder of the first printed circuit board assembly, replacing the removed part of the first printed circuit board assembly with a second printed circuit board assembly as described herein having the same shape and size as the removed part of the first printed circuit board assembly, providing a connector as described herein, and mechanically and electrically connecting the remainder of the first printed circuit board assembly to the second printed circuit board assembly. The remainder of the first printed circuit board assembly is connected to the second printed circuit board assembly by screwing the first plurality of arms of the connector to the connector-receiving portion of the remainder of the first printed circuit board assembly, screwing the second plurality of arms of the connector to the connector-receiving portion of the second printed circuit board assembly, soldering the first plurality of pins of the connector to the pads of the connector-receiving portion of the remainder of the first printed circuit board assembly, and soldering the second plurality of pins of the connector to the pads of the connector-receiving portion of the second printed circuit board assembly.

This solution is beneficial because the method of the invention can be used to repair the first printed circuit board assembly if the first printed circuit board assembly has a damaged area by removed a part of the first printed circuit board assembly which includes the damaged area and replacing it with the second printed circuit board assembly. This saves cost in comparison to scrapping and replacing the first printed circuit board assembly entirely.

On the other hand, the method of the invention can also be used to replace part of the first printed circuit board assembly with a second printed circuit board assembly having a different circuit design, even if the first printed circuit board assembly is not damaged. Thus, the method of the invention can also be used to modify a printed circuit board assembly, rather than scrapping and replacing it completely, which also saves costs.

Removing a part of the first printed circuit board assembly by laser cutting is beneficial because laser cutting machines for printed circuit boards can now achieve an accuracy of cut of as little as 20 micrometres.

Further features, goals and advantages of the present invention will now be described in association with the accompanying drawings, in which exemplary components of the invention are illustrated. Components of the devices and methods according to the invention which are at least essentially equivalent to each other with respect to their function can be marked by the same reference numerals, wherein such components do not have to be marked or described in all of the drawings.

In the following description, the invention is described by way of example only with respect to the accompanying drawings.

### Brief Description of the Drawings

Fig. 1 is a schematic diagram of an LED display cabinet;
Fig. 2A is a schematic diagram of a first arrangement of LED display modules;
Fig. 2B is a schematic diagram of a second arrangement of LED display modules;
Fig. 3 is a close-up plan view of a part of a front surface of an embodiment of a printed circuit board assembly;
Fig. 4A is a close-up plan view of a part of a rear surface of an embodiment of a printed circuit board assembly;
Fig. 4B is a close-up plan view of a part of a rear surface of a printed circuit board assembly which does not form part of the claimed invention;
Fig. 5A is a bottom plan view, schematically showing a rear surface of an embodiment of a printed circuit board assembly;
Fig. 5B is a bottom plan view, schematically showing a rear surface of another embodiment of a printed circuit board assembly;
Fig. 6 is a schematic diagram of an arrangement of printed circuit board assemblies according to an embodiment of the invention;
Fig. 7 is an isometric view, schematically showing an embodiment of a connector;
Fig. 8A is a top plan view, schematically showing the connector of Fig. 7;
Fig. 8B is a side elevational view, schematically showing the connector of Fig. 7;
Fig. 8C is a bottom plan view, schematically showing the connector of Fig. 7;
Fig. 9A is the top plan of Fig. 8A, schematically showing dimensions thereof;
Fig. 9B is the side elevational view of Fig. 8B, schematically showing dimensions thereof;
Fig. 10A is an isometric view, schematically showing the connector of Fig. 7 joining two printed circuit board assemblies together;
Fig. 10B is a side elevational view, schematically showing the same combination of elements as in Fig. 10A;
Fig. 11 is a close-up plan view of a part of a rear surface of an embodiment of a printed circuit board assembly, schematically showing the same combination of elements as in Fig. 10A;
Fig. 12 is a bottom plan view, schematically showing a rear surface of an embodiment of a printed circuit board assembly, which has been repaired using the connector of Fig. 7;
Fig. 13 is a schematic diagram of an arrangement of printed circuit board assemblies, which has been repaired in two different locations; and
Fig. 14 is a flow diagram schematically representing an embodiment of a method of repairing a printed circuit board assembly.

### Detailed Description

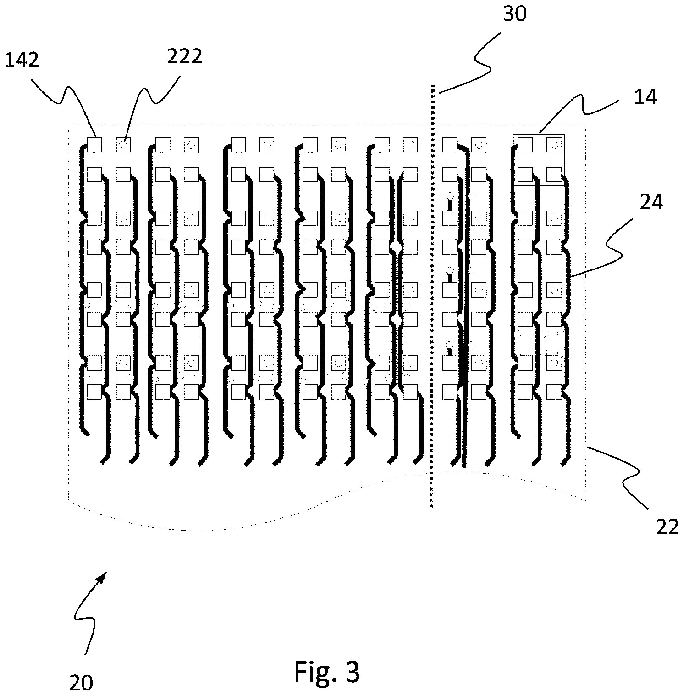

Fig. 3 schematically shows a part of a front surface of an embodiment of a printed circuit board assembly 20. The PCBA 20 comprises a printed circuit board 22, on which are mounted a plurality of evenly spaced electronic components. In this embodiment, these electronic components are LED packages 14. Each of the LED packages 14 comprises four LED package pins 142, by means of which the LED packages 14 are mechanically and electrically connected to the printed circuit board 22. Some of the electrical connections are made by connecting lines 24 formed on the front surface of the printed circuit board 22. Other of the electrical connections are made through vias 222, which penetrate through the printed circuit board 22 to a rear surface of the printed circuit board 22. Fig. 3 also shows that the PCBA 20 comprises a line 30 for laser cutting between the electronic components on the front surface of the printed circuit board 22. As can be seen, the line 30 is aligned parallel to an edge of the printed circuit board 22.

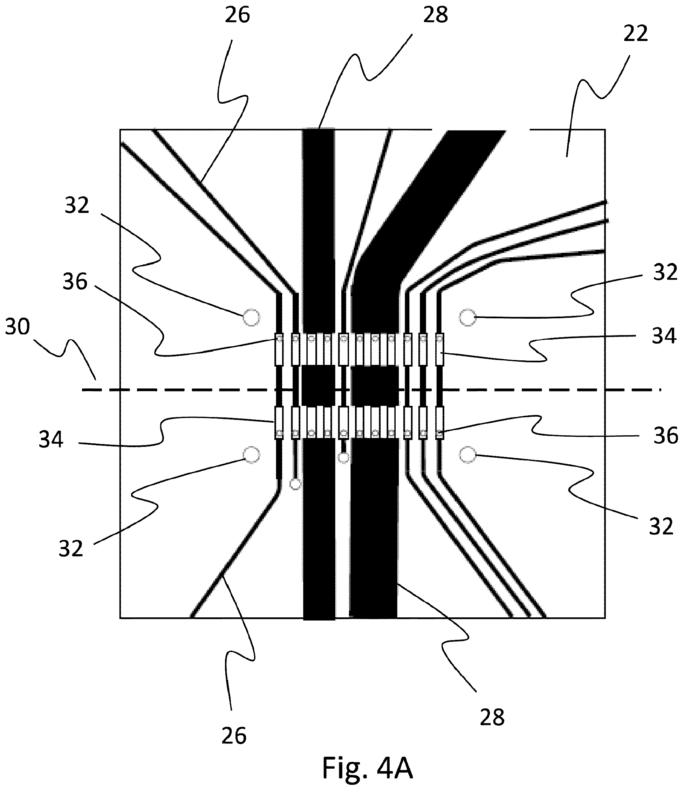

Fig. 4A schematically shows a part of a rear surface of the PCBA 20 shown in Fig. 3. The PCBA 20 comprises a plurality of electrically conducting connections 26, 28 on a rear surface of the printed circuit board 22. Some of these electrically conducting connections are conducting lines 26, whereas other of them are wider conducting strips 28, both of a type which can commonly be found on printed circuit boards. The electrically conducting connections 26, 28 help to form connections between the electronic components 14 on the front surface of the printed circuit board 22, as well as with other elements of the PCBA 20, such as drivers for the LED packages 14, capacitors, controllers, and so on.

In addition to these commonly found elements, Fig. 4A shows that the PCBA 20 further comprises a line 30 for laser cutting across the electrically conducting connections 26, 28 on the rear surface of the printed circuit board 22. The line 30 visible in Fig. 4A is the same as the line 30 visible in Fig. 3, just seen from the opposite side of the printed circuit board 22. The rear surface of the printed circuit board 22 also comprises a plurality of screw holes 32, which are perpendicular to the front and rear surfaces of the printed circuit board 22, and a plurality of evenly spaced, electrically conducting pads 34. The screw holes 32 and the electrically conducting pads 34 are both elements of a connector-receiving portion of the PCBA 20. During normal operation of the PCBA 20, this connector-receiving portion serves no function. PCBA 20 is accidentally damaged, the connector-receiving portion can be used to carry out a repair, as will be described in greater detail below.In the embodiment shown in Fig. 4A, each of the electrically conducting pads 34 comprises a blind hole 36 perpendicular to the rear surface of the printed circuit board 22. The holes 36 are blind because they do not penetrate through to the front surface of the printed circuit board 22.

As can also be seen in Fig. 4A, each of the electrically conducting connections 26, 28 which is traversed by the laser cutting line 30 is electrically connected to at least one of the electrically conducting pads 34. Moreover, a separation between the screw holes 32 is equal to an integral multiple of the spacing between the electronic components 14 on the front surface of the printed circuit board 22, and the respective locations of the screw holes 32 on the rear surface is offset from the respective locations of the electronic components 14 on the front surface by half the spacing between the electronic components 14 on the front surface. Thus the screw holes 32 are located between the electronic components 14 on the front surface of the printed circuit board 22 and do not interfere with them.

In the embodiment shown in Fig. 4A, the connector-receiving portion comprises a plurality of screw holes 32 and a plurality of electrically conducting pads 34 on both sides of the line 30 for laser cutting. However, at least one of these pluralities of screw holes 32 and pluralities of electrically conducting pads 34 are arranged on the opposite side of the line 30 from the edge of the printed circuit board 22 which the line 30 lies parallel to.

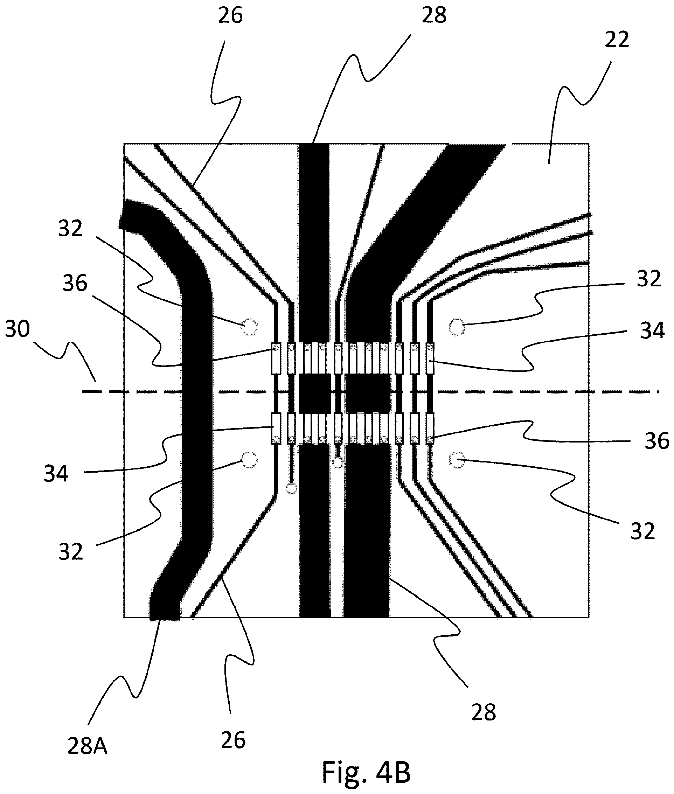

Fig. 4B is included for the sake of comparison with Fig. 4A, and schematically shows a part of a rear surface of a PCBA which does not form part of the present invention. This is because, as may be seen in Fig. 4B, one of the electrically conducting strips 28A is not electrically connected to at least one of the electrically conducting pads 34. Therefore, if the PCBA of Fig. 4B were to be cut along the line 30, the part of the conducting strip 28A remaining on one side of the line 30 could not be connected to another PCBA on the other side of the line 30 using a connector of the invention.

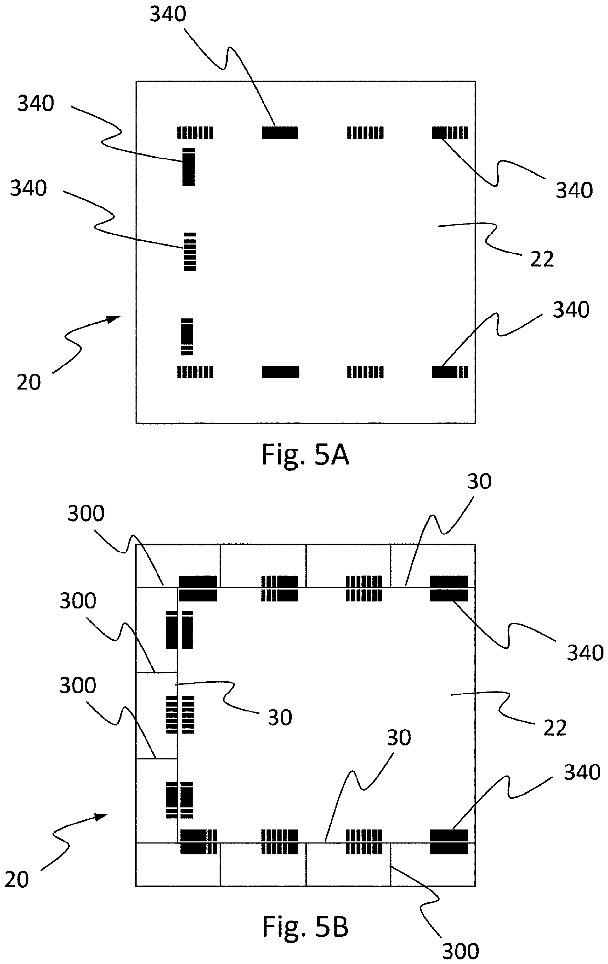

Fig. 5A schematically shows a rear surface of an embodiment of a PCBA 20. As may be seen in Fig. 5A, the rear surface of the printed circuit board 22 comprises a plurality of similarly sized connector-receiving portions 340, which are arranged parallel to three of the edges of the rear surface of the printed circuit board 22. All of these connector-receiving portions 340 are inset from the edges they are each respectively parallel to. This allows a line 30 for laser cutting between the electronic components 14 on the front surface of the printed circuit board 22 and across the electrically conducting connections 26, 28 on the rear surface of the printed circuit board 22 to be positioned such that it is aligned parallel to each of these three edges, with both the screw holes 32 and the electrically conducting pads 34 of the connector-receiving portions 340 arranged on the opposite side of the respective line 30 from the parallel edge.

This can be further understood by reference to Fig. 5B, which schematically shows a rear surface of another embodiment of a PCBA 20. In Fig. 5B, the PCBA 20 comprises three lines 30 for laser cutting between the electronic components 14 on the front surface of the printed circuit board 22 and across the electrically conducting connections 26, 28 on the rear surface of the printed circuit board 22. Each of these lines 30 is aligned parallel to a respective one of the three edges of the printed circuit board 22 which have connector-receiving portions 340 arranged parallel to them as well. In this embodiment, each of the connector-receiving portions 340 comprises a plurality of screw holes 32 and a plurality of electrically conducting pads 34 on both sides of a respective one of the three lines 30. However, at least one of these pluralities of screw holes 32 and pluralities of electrically conducting pads 34 are arranged on the opposite side of the respective line 30 from the edge of the printed circuit board 22 which the line 30 lies parallel to.

In addition to the lines 30, the PCBA 20 in the embodiment of Fig. 5B also comprises a plurality of shorter laser cutting lines 300. Each of these shorter laser cutting lines 300 connects an edge of the printed circuit board 22 to whichever one of the three lines 30 is parallel to that edge. Unlike the lines 30, the shorter lines 300 allow laser cutting both between the electronic components 14 on the front surface of the printed circuit board 22 and between the electrically conducting connections 26, 28 on the rear surface of the printed circuit board 22. Thus, cutting along one of the shorter lines 300 will not sever any electrical connections. This allows a part of the PCBA 20 which is rectangular in shape, having two short edges and two long edges, to be removed from a corner or edge of the PCBA 20. Thus, if a corner or edge of the PCBA 20 is accidentally damaged, a rectangular part around the damaged area can be removed by laser cutting along one or two of the shorter lines 300 and part of a line 30, to leave a rectangular hole with a connector-receiving portion 340 next to one of its long edges. Since cutting along any of the shorter lines 300 does not sever any electrical connections, all of the electrical connections to the removed part of the PCBA 20 can be restored through this connector-receiving portion 340. This is possible since as described above in relation to Figs. 4A and 4B, each of the electrically conducting connections 26, 28 on the rear surface of the printed circuit board 22 is electrically connected to at least one of the electrically conducting pads 34 of the connector-receiving portion 340.

Whereas in Fig. 5B, the shorter lines 300 are all shown to be perpendicular to an edge of the printed circuit board 22, and are therefore also perpendicular to one of the laser cutting lines 30, they do not need to be. Each of the shorter lines 300 can have any shape or orientation, provided that they pass both between the electronic components 14 on the front surface of the printed circuit board 22 and between the electrically conducting connections 26, 28 on the rear surface of the printed circuit board 22. However, making the shorter lines 300 straight and perpendicular in the manner shown in Fig. 5B is the most convenient solution, because the removed part of the PCBA 20 is then rectangular in shape, rather than having an irregular shape, which makes it easier to replace.

As may also be seen in both of Figs. 5A and 5B, a gap between adjacent ones of the plurality of connector-receiving portions 340 which are arranged on the same side of a line 30 as each other is not greater than one-and-a-half times a length of the connector-receiving portions 340 themselves. This means that an accidentally damaged area of the PCBA 20 will never be very far away from a connector-receiving portion 340 to allow a suitable repair to be carried out.

When a repair is performed by removing and replacing a part of the PCBA 20 around a damaged area, the replacement part should have the same shape and size as the removed part of the PCBA 20. Therefore, if the removed part of the PCBA 20 is rectangular in shape, the printed circuit board 22 of the replacement part should also be rectangular in shape, having two short edges and two long edges, and with a connector-receiving portion 340 of its own arranged alongside at least one of the two long edges. The replacement part can then be inserted into the rectangular hole left by the removed part of the PCBA 20, with the connector-receiving portion 340 of the replacement part facing one of the connector-receiving portions 340 on the rear surface of the PCBA 20. The location of the connector-receiving portion 340 on the replacement part needs to be carefully aligned with the location of the connector-receiving portion 340 on the rear surface of the PCBA 20. However, this can easily be achieved by standardizing the size of the replacement parts which are made available and by making the distance between adjacent ones of the shorter laser cutting lines 300 equal to the standardized width of the replacement parts, as is shown in Fig. 5B.

In the embodiment of Fig. 5B, the rectangular replacement parts are of three different types, corresponding to the three edges of the printed circuit board 22 which have connector-receiving portions 340 arranged parallel to them. The three different types of replacement part respectively comprise a connector-receiving portion 340 located in the middle of a long edge, at the left-hand side of a long edge, and at the right-side of a long edge of the replacement part. This allows just three different types of replacement part to be used to repair damaged areas at any location along the edges or corners of the PCBA 20. However, in other embodiments, a greater or lesser number of different types of replacement part may be used instead.

In cases like the embodiment of Fig. 5B, it is more convenient for the connector-receiving portions 340 to have a length which is shorter than the two short edges of the printed circuit board 22 of the replacement part. This allows the connector-receiving portion 340 of a replacement part for a damaged corner of the PCBA 20 to be easily aligned with the location of a connector-receiving portion 340 on the rear surface of the PCBA 20, as shown in Fig. 5B.

On the other hand, the layout of the electronic components 14 on the front surface of the printed circuit board 22 of the replacement part and/or the pattern of the electrically conducting connections 26, 28 on the rear surface of the printed circuit board 22 of the replacement part do not have to be the same as the layout of the electronic components 14 on the front surface of the removed part of the PCBA 20 and/or the pattern of the electrically conducting connections 26, 28 on the rear surface of the removed part of the PCBA 20. In this way, if desired, the removed part of the PCBA 20 may be replaced with a replacement part having a different circuit design, even if the shape and size of the replacement part are the same as the shape and size of the removed part of the PCBA 20 which is being repaired.

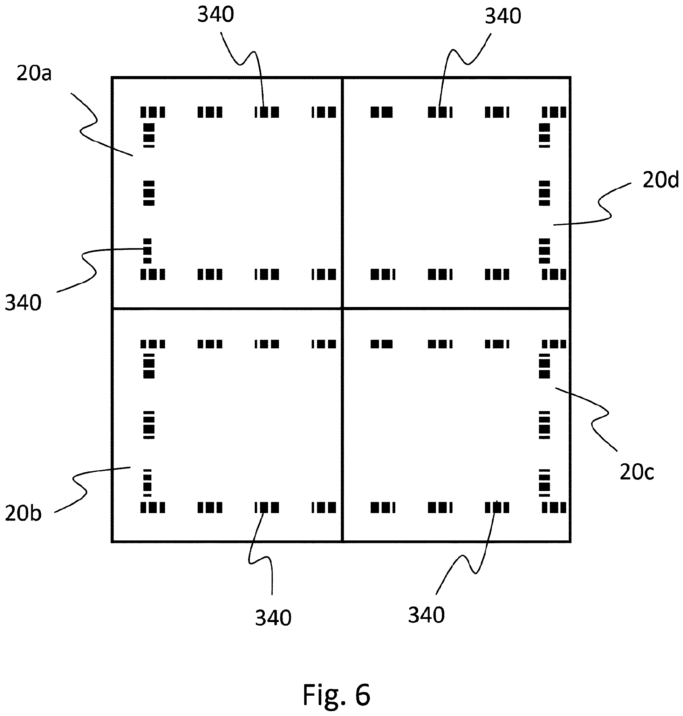

Fig. 6 schematically shows an arrangement of four printed circuit board assemblies 20a, 20b, 20c, 20d, each of which is similar to the PCBA 20 shown in Fig. 5A. Fig. 6 therefore shows how a plurality of such printed circuit board assemblies may be arranged together to create an arrangement of LED display modules similar to that shown in Fig. 2A, with the significant difference that the arrangement shown in Fig. 6 now has connector-receiving portions 340 arranged parallel to its entire periphery. Thus, any accidental damage to the edges or corners of the arrangement of Fig. 6 may be repaired, even though each individual one of the printed circuit board assemblies 20a, 20b, 20c, 20d only has connector-receiving portions 340 arranged parallel to three of their respective edges. In fact, the same result may be achieved with connector-receiving portions 340 arranged parallel to just two perpendicular edges of each of the printed circuit board assemblies 20a, 20b, 20c, 20d.

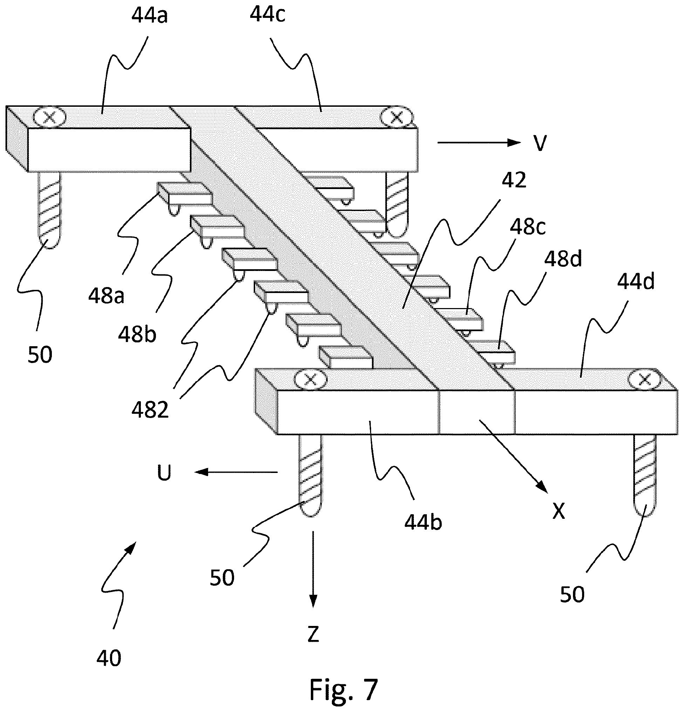

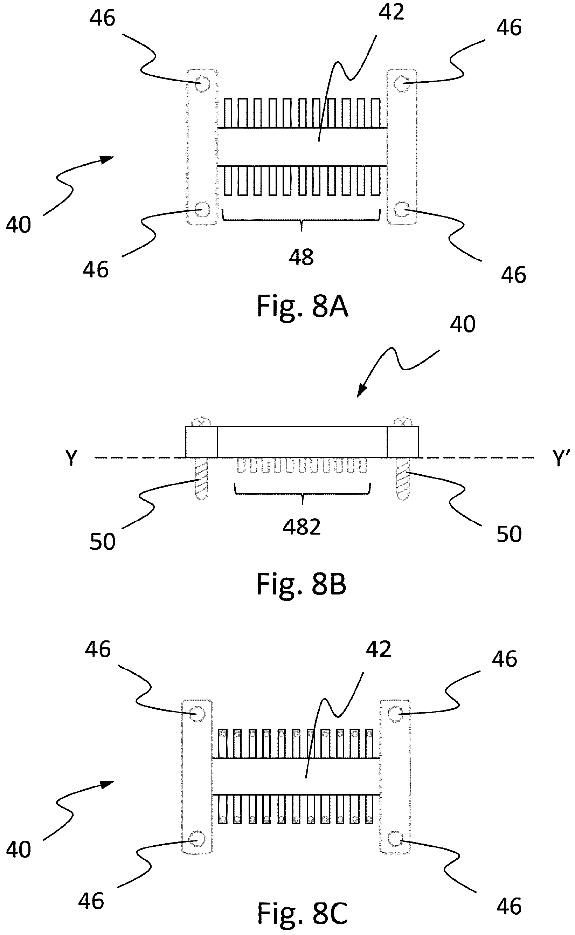

Fig. 7 schematically shows an embodiment of a connector 40, for connecting the connector-receiving portion 340 on a replacement part to one of the connector-receiving portions 340 on the PCBA 20 which is being repaired. The connector 40 comprises a rigid, electrically insulating elongate body 42, whose length defines a first direction X. During a repair, the elongate body 42 is laid along one of the laser cutting lines 30, *i.e.* parallel to the direction X. A first plurality of rigid, electrically insulating arms 44a, 44b projects from the elongate body 42 in a second direction U, which is perpendicular to the first direction X. A second plurality of rigid, electrically insulating arms 44c, 44d projects from the elongate body 42 in a third direction V, which is opposite to the second direction U. Each of the arms 44a, 44b, 44c, 44d respectively comprises a through-hole 46 (which may be seen in the top and bottom plan views of Figs. 8A and 8C) in a fourth direction Z, which is perpendicular to the first and second directions X, U. These through-holes 46 allow the first plurality of arms 44a, 44b to be screwed to the connector-receiving portion 340 on the PCBA 20 which is being repaired, by means of screws 50, which are inserted into the screw holes 32 of the connector-receiving portion 340 on the PCBA 20. The through-holes 46 are internally threaded to hold the screws 50 therein in the manner shown in Fig. 7. Similarly, the second plurality of arms 44c, 44d can be screwed to a connector-receiving portion 340 on the replacement part by means of screws 50 held in the through-holes 46 of the second plurality of arms 44c, 44d and inserted into the screw holes 32 of the connector-receiving portion 340 on the replacement part. Since each respective one of the first plurality of arms 44a, 44b is mechanically connected to a respective one of the second plurality of arms 44c, 44d, the replacement part therefore becomes mechanically connected to the PCBA 20.

The connector 40 also comprises a first plurality of evenly spaced, electrically conducting pins 48a, 48b projecting from the elongate body 42 in the second direction U, and a second plurality of evenly spaced, electrically conducting pins 48c, 48d projecting from the elongate body in the third direction V. The first plurality of pins 48a, 48b can be soldered to respective ones of the pads 34 of the connector-receiving portion 340 on the PCBA 20 and the second plurality of pins 48c, 48d can be soldered to respective ones of the pads 34 of the connector-receiving portion 340 on the replacement part. Since each respective one of the first plurality of pins 48a, 48b is electrically connected to a respective one of the second plurality of pins 48c, 48d, the electrically conducting connections 26, 28 on the rear surface of the printed circuit board 22 of the PCBA 20 therefore become electrically connected to the electrically conducting connections 26, 28 on the rear surface of the printed circuit board 22 of the replacement part via the pins.

The spacing between the first plurality of pins 48a, 48b is equal to the spacing between the electrically conducting pads 34 on the rear surface of the printed circuit board 22 of the PCBA 20 which is being repaired. Similarly, the spacing between the second plurality of pins 48c, 48d is equal to the spacing between the electrically conducting pads 34 on the rear surface of the printed circuit board 22 of the replacement part. This ensures that the pins of the connector 40 line up with the pads 34 they are being soldered to. On the other hand, it also means that a connector 40 has pins with a spacing which is specifically adapted to a particular connector-receiving portion 340. For example, a connector 40 having pins with a spacing of 2.5 mm cannot be soldered to a printed circuit board which has pads 34 with a spacing of 2.6 mm.

To help the electrically conducting pins to be soldered to the pads 34, in the embodiment shown in Fig. 7, each of the pins 48 respectively comprises a lead 482, which projects from its respective pin in the fourth direction Z. These leads 482 engage with the blind holes 36 of the corresponding pads 34, which were described above in relation to Fig. 4A.

In addition, the size of and separation between the through-holes 46 in the first plurality of arms 44a, 44b is equal to the size of and separation between the corresponding screw holes 32 of the connector-receiving portion 340 on the PCBA 20. Similarly, the size of and separation between the through-holes 46 in the second plurality of arms 44c, 44d is equal to the size of and separation between the corresponding screw holes 32 of the connector-receiving portion 340 on the replacement part. This ensures that the through-holes 46 of the connector 40 line up with the screw holes 32 of the connector-receiving portions 340 on the rear surface of the printed circuit boards 22 of both the PCBA 20 and the replacement part.

Moreover, since the separation between the through-holes 46 in the first plurality of arms 44a, 44b is equal to the separation between the through-holes 46 in the second plurality of arms 44c, 44d, it follows that the layout of the connector-receiving portion on the replacement part is also matched to the layout of the connector-receiving portion on the PCBA 20.

Figs. 8A, 8B and 8C respectively schematically show top plan, side elevational and bottom plan views of the connector 40 of Fig. 7. As may be seen from the side elevational view of Fig. 8B, in this embodiment, all of the arms 44a, 44b, 44c, 44d and all of the pins 48a, 48b, 48c, 48d each have a respective flat surface, which surfaces are coplanar with each other and together define a plane Y-Y' from which the leads 482 of the pins project. This means that once the connector 40 has been connected to the printed circuit boards 22 of both the replacement part and the PCBA 20, the connector 40 sits flush with the rear surfaces of both the printed circuit boards 22, thereby increasing the strength of their mechanical connection.

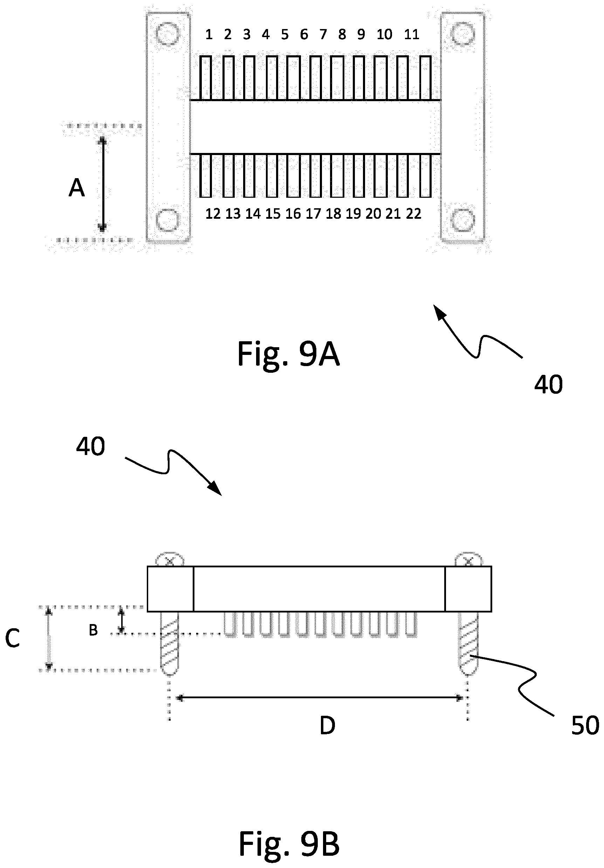

Figs. 9A and 9B reprise the top plan and side elevational views of the connector 40 shown in Figs. 8A and 8B, but with different annotations for the sake of further explanation. Referring firstly to Fig. 9A, the first plurality of pins are respectively numbered 1, 2, 3, ... and the second plurality of pins are respectively numbered 12, 13, 14, .... Pin no. 1 is electrically connected to pin no. 12, pin no. 2 is electrically connected to pin no. 13, pin no. 3 is electrically connected to pin no. 14, and so on. The labels A, B, C and D in Figs. 9A and 9B respectively denote the length of the arms 44, the length of the leads 482, the length of each screw 50 which is exposed before it is screwed into a screw hole 32, and the separation between the through-holes 46. The dimensions A and D both depend on the spacing between the electronic components 14 on the front surface of the printed circuit board 22, whereas the dimensions B and C both depend on the thickness of the printed circuit board 22, since a thicker printed circuit board can accommodate longer screws 50 and leads 482.

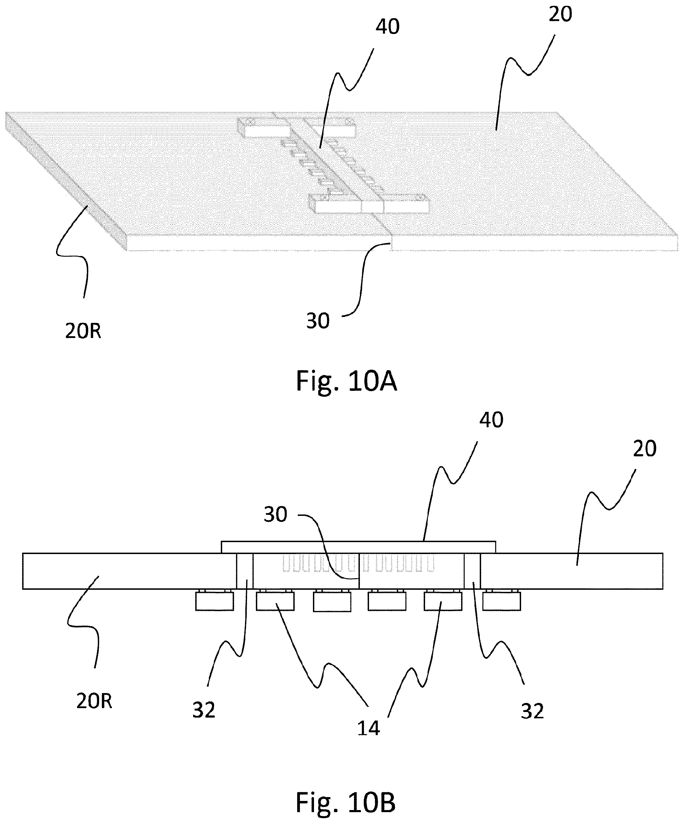

Figs. 10A and 10B both schematically show the connector 40 of Fig. 7 being used to join a replacement part 20R to a PCBA 20. Fig. 10A shows how the elongate body 42 of the connector 40 is laid along a laser cutting line 30. Fig. 10B shows how the screw holes 32 in both the replacement part 20R and the PCBA 20 are positioned between the electronic components 14 on the front surfaces of the printed circuit boards 22 of each assembly, and therefore do not interfere with the electronic components 14.

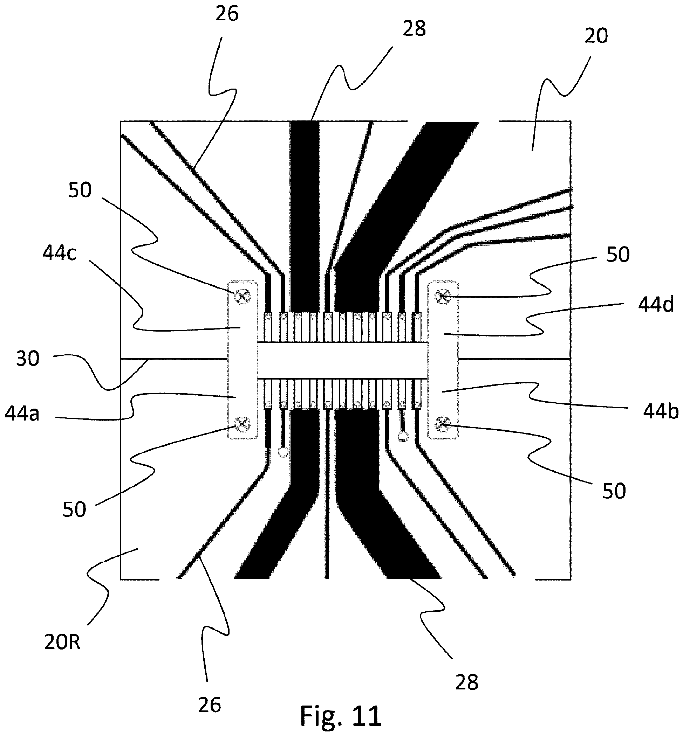

Fig. 11 also schematically shows the connector 40 of Fig. 7 being used to join a replacement part 20R to a PCBA 20. By comparing Fig. 11 with Fig. 4A, it can be seen how the connector 40 overlies the connector-receiving portions 340 on the rear surfaces of the printed circuit boards 22 of both the replacement part 20R and the PCBA 20, so that the screws 50 are aligned with the screw holes 32, the pins of the connector 40 are aligned with the pads 34, and the elongate body 42 of the connector 40 overlies the laser cutting line 30.

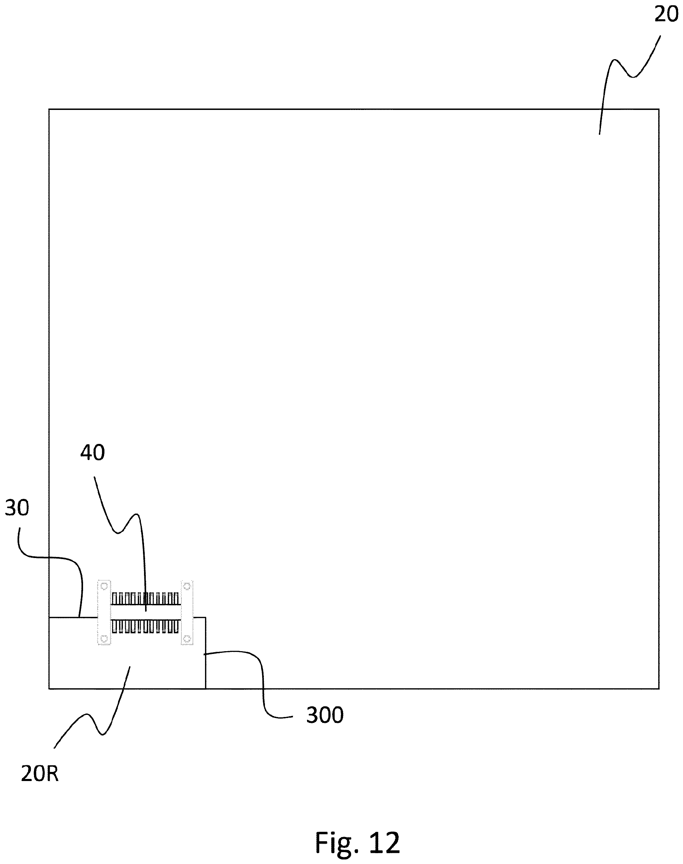

Whereas Fig. 11 is a close-up plan view of just a part of a rear surfaces of the PCBA 20 and the replacement part 20R, Fig. 12 shows the entire rear surfaces of the PCBA 20 and the replacement part 20R, in order to put the parts of each which are shown in Fig. 11 in context. In Fig, 12, other features which would in reality be visible on the rear surfaces of both the PCBA 20 and the replacement part 20R have been omitted for greater clarity. In the example shown in Fig. 12, the replacement part 20R has been used to replace a damaged area at a corner of the PCBA 20.

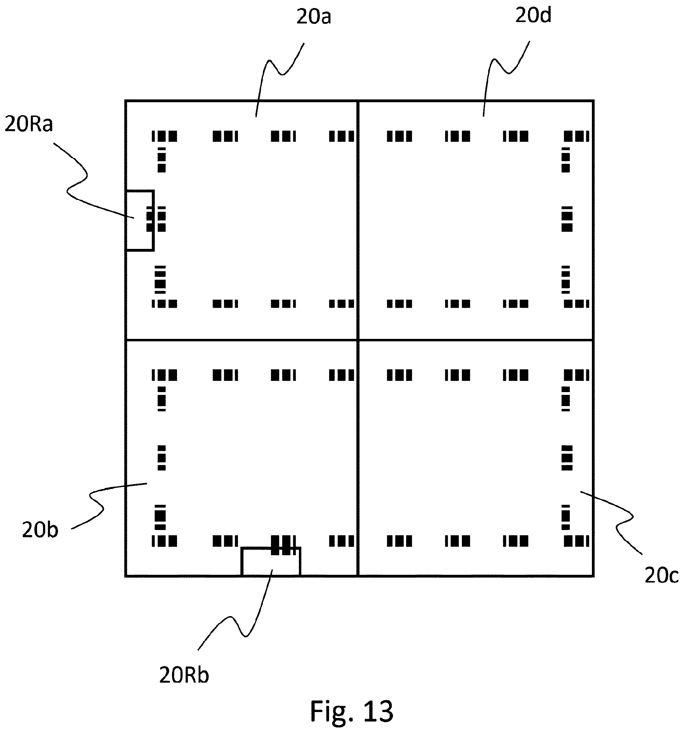

Fig. 13 schematically shows the same arrangement of four printed circuit board assemblies 20a, 20b, 20c, 20d as is shown in Fig. 6, wherein the PCBAs 20a and 20b have both been subject to repairs in the manner described above. Thus, a first damaged area on a left-hand edge of the PCBA 20a has been removed and replaced with a replacement part 20Ra and a second damaged area on a bottom edge of the PCBA 20b has been removed and replaced with a replacement part 20Rb. Thus, neither of the PCBAs 20a and 20b needs to be scrapped and replaced, thereby saving considerable cost in comparison to replacing both of the PCBAs 20a and 20b, which would otherwise have entailed replacing half of the entire arrangement of four printed circuit board assemblies 20a, 20b, 20c, 20d.

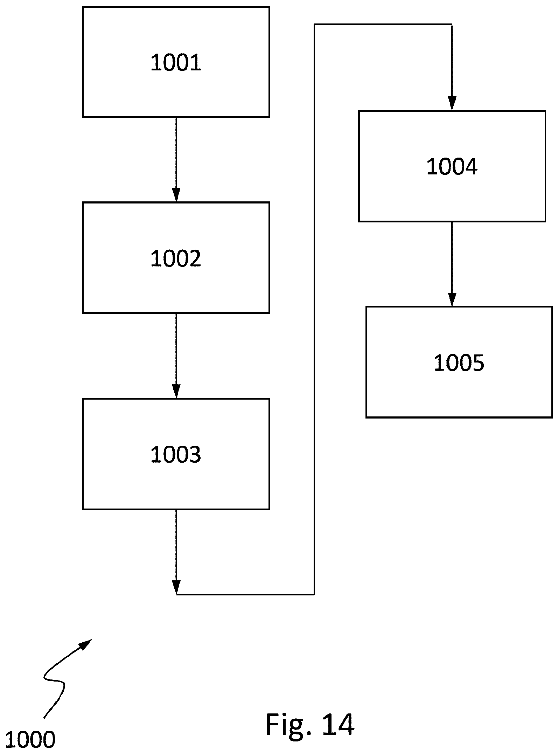

Fig. 14 is a flow diagram schematically representing an embodiment of a method 1000 of repairing a printed circuit board assembly. The method 1000 comprises providing 1001 a PCBA 20, such as that shown in Fig. 5A, and removing 1002 a part of the PCBA 20 by laser cutting, including cutting along the line 30 for laser cutting between the electronic components 14 on the front surface of the printed circuit board 22 of the PCBA 20 and across the electrically conducting connections 26, 28 on the rear surface of the printed circuit board 22 of the PCBA 20, to leave a remainder of the PCBA 20. The method 1000 then comprises replacing 1003 the removed part of the PCBA 20 with a printed circuit board assembly 20R, such as the replacement parts 20Ra and 20Rb shown in Fig. 13, which have the same shape and size as the removed part of the PCBA 20. The method 1000 then comprises providing 1004 a connector 40, such as the connector 40 shown in Figs. 7 to 9B, and mechanically and electrically connecting 1005 the remainder of the PCBA 20 to the replacement printed circuit board assembly 20R. The mechanical and electrical connection 1005 is achieved by screwing the first plurality of arms 44a, 44b of the connector 40 to the connector-receiving portion 340 of the remainder of the PCBA 20, screwing the second plurality of arms 44c, 44d of the connector 40 to the connector-receiving portion 340 of the replacement printed circuit board assembly 20R, soldering the first plurality of pins 48a, 48b of the connector 40 to the pads of the connector-receiving portion 340 of the remainder of the PCBA 20, and soldering the second plurality of pins 48c, 48d of the connector 40 to the pads of the connector-receiving portion 340 of the replacement printed circuit board assembly 20R.

In summary, therefore, the present invention provides a technique for repairing a damaged printed circuit board assembly, wherein the PCBA at least comprises a printed circuit board, a plurality of electronic components mounted on a front surface of the printed circuit board and a plurality of electrically conducting connections between the electronic components on a rear surface of the printed circuit board. The technique comprises providing the PCBA with a laser cutting line, which is positioned to cut between the electronic components on the front surface but across the electrically conducting connections on the rear surface. The laser cutting line is arranged parallel to an edge of the PCBA. Each of the electrically conducting connections traversed by the laser cutting line is electrically connected to at least one electrically conducting pad of a connector-receiving portion also on the rear surface, which is located on an opposite side of the laser cutting line from the edge of the PCBA which the laser cutting line is parallel to. Thus, if the PCBA is accidentally damaged at its edge or corner, the damaged area may be removed by cutting along the laser cutting line with a laser, and inserting a replacement part of PCBA having the same shape and size as the removed part of the PCBA into the hole left behind by the removed part of the PCBA. The replacement part of PCBA also comprises a connector-receiving portion adjacent one of its edges, which is similar to the connector-receiving portion of the damaged PCBA. The invention also provides a connector, which is adapted to engage with the connector-receiving portions of the damaged PCBA and the replacement part of PCBA. By means of this connector, the replacement part of PCBA can be mechanically and electrically connected to the damaged PCBA, thereby repairing it. This obviates the need to scrap and replace the entire PCBA if it is accidentally damaged at its edge or corner, which saves costs.

**Reference Numerals:**

| | | | |
|---|---|---|---|
| 10 | LED display | 42 | Elongate body |
| 12a, 12b, 12c, 12d | LED display modules | 44a, 44b | First plurality of arms |
| 14 | LED packages | 44c, 44d | Second plurality of arms |
| 16 | Cabinet | | |
| 18 | Mini LED display module | 46 | Through-holes |
| 20, 20a, 20b, 20c, 20d | Printed circuit board assemblies | 48 | Pins |
| | | 48a, 48b | First plurality of pins |
| 20R, 20Ra, 20Rb | Replacement printed circuit board assemblies | | |
| | | 48c, 48d | Second plurality of pins |
| 22 | Printed circuit board | 50 | Screws |
| 24 | Connecting line | 142 | LED package pin |
| 26 | Conducting line | 222 | Via |
| 28, 28A | Conducting strip | 300 | Laser cutting line |
| 30 | Laser cutting line | 340 | Connector-receiving portion |
| 32 | Screw holes | 482 | Leads |
| 34 | Pads | 1000 | Method of repairing a PCBA |
| 36 | Blind holes | 1001 | Provide a PCBA |
| 40 | Connector | | |
| 1002 | Remove a part of the PCBA by laser cutting | C | Exposed screw length |
| 1003 | Replace the removed part of the PCBA with a patch | D | Through-hole separation |
| 1004 | Provide a connector | U | Second direction |
| 1005 | Connect the remainder of the PCBA to the patch by screwing and soldering | V | Third direction |
| | | X | First direction |
| | | Y-Y' | Plane |
| A | Arm length | Z | Fourth direction |
| B | Lead length | | |

## Claims

1. A printed circuit board assembly (20, 20R), at least comprising:
a printed circuit board (22);
a plurality of evenly spaced electronic components (14) mounted on a front surface of the printed circuit board (22);
a plurality of electrically conducting connections (26, 28) between the electronic components (14) on a rear surface of the printed circuit board (22);
wherein the rear surface of the printed circuit board (22) further comprises a connector-receiving portion (340) comprising:
a plurality of screw holes (32) perpendicular to the front and rear surfaces of the printed circuit board (22); and
a plurality of evenly spaced, electrically conducting pads (34);
wherein each of the electrically conducting connections (26, 28) between the electronic components (14) is electrically connected to at least one of the electrically conducting pads (34); and
wherein a separation between the screw holes (32) is equal to an integral multiple of the spacing between the electronic components (14) on the front surface, and the respective locations of the screw holes (32) is offset from the respective locations of the electronic components (14) on the front surface by half the spacing between the electronic components (14) on the front surface.

2. A printed circuit board assembly (20, 20R) according to claim 1, wherein each of the electrically conducting pads (34) of the connector-receiving portion (340) comprises a blind hole (36) perpendicular to the rear surface of the printed circuit board (22).

3. A printed circuit board assembly (20, 20R) according to claim 1 or claim 2, wherein each of the evenly spaced electronic components (14) on the front surface of the printed circuit board (22) comprises an LED package.

4. A printed circuit board assembly (20) according to any one of the preceding claims, further comprising a line (30) for laser cutting between the electronic components (14) on the front surface of the printed circuit board (22) and across the electrically conducting connections (26, 28) on the rear surface of the printed circuit board (22);
wherein:
the line (30) for laser cutting is aligned parallel to an edge of the printed circuit board
(22); the screw holes (32) are arranged on the opposite side of the line (30) from said edge; and
the electrically conducting pads (34) are arranged on the same side of the line (30) as the screw holes (32).

5. A printed circuit board assembly (20) according to claim 4, wherein:
the rear surface of the printed circuit board (22) comprises at least two of said lines (30) for laser cutting arranged perpendicular to each other; and
a plurality of connector-receiving portions (340) are arranged on the opposite sides of the at least two lines (30) from at least two edges of the rear surface.

6. A printed circuit board assembly (20) according to claim 5, wherein a gap between adjacent ones of the plurality of connector-receiving portions (340) is not greater than one-and-a-half times a length of the connector-receiving portions (340).

7. A printed circuit board assembly (20R) according to any one of claims 1 to 3, wherein the printed circuit board (22) is rectangular in shape, having two short edges and two long edges, and a connector-receiving portion (340) is arranged alongside at least one of the two long edges.

8. A printed circuit board assembly (20R) according to claim 7, wherein the connector-receiving portion (340) has a length which is shorter than the two short edges of the rectangular printed circuit board (22).

9. A connector (40) comprising:
a rigid, electrically insulating elongate body (42), whose length defines a first direction (X);
a first plurality of rigid, electrically insulating arms (44a, 44b) projecting from the elongate body (42) in a second direction (U) perpendicular to the first direction (X);
a second plurality of rigid, electrically insulating arms (44c, 44d) projecting from the elongate body (42) in a third direction (V) opposite to the second direction (U);
wherein each respective one of the first plurality of arms (44a, 44b) is mechanically connected to a respective one of the second plurality of arms (44c, 44d), and each of the arms (44a, 44b, 44c, 44d) respectively comprises a through-hole (46) in a fourth direction (Z) perpendicular to the first and second directions (X, U);
a first plurality of evenly spaced, electrically conducting pins (48a, 48b) projecting from the elongate body (42) in the second direction (U);
a second plurality of evenly spaced, electrically conducting pins (48c, 48d) projecting from the elongate body in the third direction (V);
wherein each respective one of the first plurality of pins (48a, 48b) is electrically connected to a respective one of the second plurality of pins (48c, 48d);
wherein a separation between the through-holes (46) in the first plurality of arms (44a, 44b) is equal to a separation between the through-holes (46) in the second plurality of arms (44c, 44d).

10. A connector according to claim 9, wherein each of the electrically conducting pins (48a, 48b, 48c, 48d) respectively comprises a lead (482) projecting from its respective pin in the fourth direction (Z).

11. A connector according to claim 10, wherein all of the arms (44a, 44b, 44c, 44d) and all of the pins (48a, 48b, 48c, 48d) each have a respective flat surface, which surfaces are coplanar with each other and together define a plane (Y-Y') from which the leads (482) of the pins project.

12. A connector according to any one of claims 9 to 11, wherein the through-holes (46) are internally threaded to hold a screw (50) therein.

13. A system comprising:
a first printed circuit board assembly (20) according to claim 4; and
a connector (40) according to claim 9;
wherein the size of and separation between the respective through-holes (46) of the connector (40) is equal to the size of and separation between the respective screw holes (32) in the first printed circuit board assembly (20), and the spacing between the first plurality of pins (48a, 48b) of the connector (40) is equal to the spacing between the electrically conducting pads (34) on the first printed circuit board assembly (20).

14. A system according to claim 13, further comprising a second printed circuit board assembly (20R) according to claim 7, wherein the size of and separation between the respective screw holes (32) in the second printed circuit board assembly (20) is equal to the size of and separation between the respective through-holes (46) of the connector (40), and the spacing between the electrically conducting pads (34) on the second printed circuit board assembly (20) is equal to the spacing between the second plurality of pins (48c, 48d) of the connector (40).

15. A method (1000) of repairing a printed circuit board assembly (20), comprising:
providing (1001) a first printed circuit board assembly (20) according to any one of claims 4 to 6;
removing (1002) a part of the first printed circuit board assembly (20) by laser cutting, including cutting along the line (30) for laser cutting between the electronic components (14) on the front surface of the printed circuit board (22) of the first printed circuit board assembly (20) and across the electrically conducting connections (26, 28) on the rear surface of the printed circuit board (22) of the first printed circuit board assembly (20), to leave a remainder of the first printed circuit board assembly (20);
replacing (1003) the removed part of the first printed circuit board assembly (20) with a second printed circuit board assembly (20R) according to claim 7 or claim 8 having the same shape and size as the removed part of the first printed circuit board assembly (20);
providing (1004) a connector (40) according to any one of claims 9 to 12; and
mechanically and electrically connecting (1005) the remainder of the first printed circuit board assembly (20) to the second printed circuit board assembly (20R) by:
screwing the first plurality of arms (44a, 44b) of the connector (40) to the connector-receiving portion (340) of the remainder of the first printed circuit board assembly (20),
screwing the second plurality of arms (44c, 44d) of the connector (40) to the connector-receiving portion (340) of the second printed circuit board assembly (20R),
soldering the first plurality of pins (48a, 48b) of the connector (40) to the pads (34) of the connector-receiving portion (340) of the remainder of the first printed circuit board assembly (20), and
soldering the second plurality of pins (48c, 48d) of the connector (40) to the pads (34) of the connector-receiving portion (340) of the second printed circuit board assembly (20R).
